# EUROPEAN PATENT APPLICATION

(11) **EP 4 376 003 A1**
(43) Date of publication of application: **29.05.2024**
(21) Application number: 22209134.0
(22) Date of filing: 23.11.2022
(51) Int. Cl.: G11C 7/10, G06F 17/16, G11C 11/412

(54) **STORAGE CELL, MEMORY, AND IN-MEMORY PROCESSOR**

(71) Applicant: Axelera AI BV, 5656 Eindhoven (NL)
(72) Inventor: Cosemans, Stefan, 5656 EINDHOVEN (NL); Rooseleer, Bram, 5656 EINDHOVEN (NL); Papistas, Ioannis, 5656 EINDHOVEN (NL); Hager, Pascal, 5656 EINDHOVEN (NL); Moons, Bert, 5656 EINDHOVEN (NL)
(74) Representative: Eisenführ Speiser

(57) **Abstract**

A storage cell for storing a binary cell signal comprises a high-keeper branch connected between a first supply potential and a cell-signal node, a force-high branch that is parallelconnected to the high-keeper branch, a low-keeper branch that is connected between the cell-signal node and a second supply potential, and a force-low branch that is parallelconnected to the low-keeper branch. These switching branches each comprise stacked MOS switches of equal conductivity type. The stacked MOS switches of the high-keeper branch are of a conductivity type that is opposite to that of those of the low-keeper branch.

The cell-signal is tapped as a potential difference between the cell-signal node and the second supply potential. An inverted cell signal is fed back from an inverter to gate the first MOS switches of the high-keeper branch and of the low-keeper branch in parallel.

## Description

The present invention relates to a storage cell, to a memory for use in an in-memory computing device, to an in-memory processor for performing matrix-vector multiplication, and to a computer comprising such a memory or such an in-memory processor.

### BACKGROUND

Traditional computer architectures based on the von Neumann computing concept split processing capability and data storage into separate physical units. In such architectures data has to be transferred between memory and arithmetic and control units.

The increasing importance of neural networks in many applications, such as technical computing and various cognitive tasks, leads to a need to efficiently perform the underlying computational operations, in particular the matrix-vector multiplications. Exemplary applications include computer vision and natural language processing, weather forecasting and financial predictions. Examples of cognitive tasks are machine learning and the development and use of cognitive models using neural networks.

The sheer number of matrix-vector multiplications required for many of such applications poses challenges in terms of power consumption and required silicon area, and hence cost. There is hence a need to accelerate these operations in a very energy-efficient way.

In these fields, traditional computer architectures exhibit both congestion in processing and high power consumption because, as mentioned, the data to be used for the multiplication operations has to be transferred between memory and arithmetic and control units through physically constrained and costly interfaces. In the specific case of matrix-vector multiplications, the complete matrix as well as the input vector for every single matrix-vector multiplication have to be transferred. Most of the energy spent in traditional computer architectures is for memory accesses.

One possibility to accelerate matrix-vector multiplications is to use dedicated hardware acceleration devices. A known concept is fusing memory and computing functions, often called "in-Memory Computing" (IMC) or "Compute-in-memory" (CIM).

One known hardware implementation of IMC is a crossbar array configuration. This circuit includes input lines and output lines, which are interconnected at cross-points defining cells. The cells contain respective memory devices, which are designed to store respective matrix coefficients. Vectors are encoded as signals applied to the input lines of the crossbar array rows, to cause the latter to perform multiply-accumulate (MAC) operations. The coefficients of the matrix ("weights") may be stored in columns of cells.

Computational units may be interweaved with the storage cells. In other words, next to every column of cells is a column of arithmetic units that can multiply the weights with input vector values to create partial products and finally accumulate all partial products to produce the outcome of a full dot-product. Such an architecture can simply and efficiently map a matrix-vector multiplication. The weights can be updated by reprogramming the memory elements, as needed to perform matrix-vector multiplications. Breaking the "memory wall" by fusing the arithmetic- and memory unit into a single IMC unit allows performing certain processing operations more efficiently in or near the memory.

In another implementation concept called near-memory computing (NMC), computational circuitry is not arranged interweaved with the memory, but closely tied to small memory banks.

Intermediate concepts including aspects of both IMC and NMC are also known.

The publication Yu-Der Chih et al., "An 89TOPS/W and 16.3TOPS/mm2 All-digital SRAM-based Full-Precision Compute-In Memory Macro in 22nm for Machine-Learning Edge Applications", 2021 IEEE International Solid- State Circuits Conference (ISSCC), DOI: 10.1109/ISSCC42613.2021 .9365760036, page 252, proposes a 6T SRAM-based all-digital CIM macro for multiply-accumulate (MAC) operations in a convolutional neural network. A higher supply voltage is required for weight updates than for MAC operations to improve energy efficiency and throughput.

### SUMMARY

The present invention aims to improve both in-memory-array computing and near-memory computing in both digital and analog implementations.

According to the present invention, a storage cell for storing a high or low bit state of a binary cell signal is provided. The storage cell comprises
- a cell switching circuit providing the cell signal, and an inverter that receives the cell signal and provides an inverted cell signal, wherein the cell switching circuit comprises the following switching branches jointly operative in keeping the bit state at high or low, or in forcing a change of the bit state to high or low:
   - a high-keeper branch connected between a first supply potential and a cell-signal node;
   - a force-high branch that is parallel-connected to the high-keeper branch;
   - a low-keeper branch that is connected between the cell-signal node and a second supply potential, and
   - a force-low branch that is parallel-connected to the low-keeper branch; wherein
- the switching branches each comprise stacked MOS switches of equal conductivity type including a respective first MOS switch and a respective second MOS switch, wherein the the stacked MOS switches of the high-keeper branch are of a conductivity type that is opposite to that of the stacked MOS switches of the low-keeper branch;
- the cell-signal is tapped as a potential difference between the cell-signal node and the second supply potential; and wherein
- the inverted cell signal is fed back from the inverter to gate the first MOS switches of the high-keeper branch and of the low-keeper branch in parallel.

In comparison with the mentioned known 6T SRAM cell and other comparable known standard SRAM cells, the circuit structure of the storage cell allows achieving several advantages. In particular, the inverted cell signal that forms the output signal of the storage cell may be provided with the full voltage swing to drive a computing segment connected to the output of the storage cell. This avoids subsequent output signal amplification and provides a strong signal for the operation of the computing segment. Furthermore, no signal treatment by assist techniques is required for performing the write operation. In particular, the write operation is robust and does not rely on a relative strength between the MOS switches. The same voltage supply level is used for updates of the stored value and for output of the stored cell signal.

Furthermore, the storage cell of the present invention requires only a small chip area and, depending on the specific implementation allows achieving a particularly high weight storage density and a tight integration with computing segments, for instance with standard logic cells, such as full adders or multipliers.

The storage cell only has a small capacitance, so that only a small amount of write energy is required per cell to be written. Moreover, the storage cell supports per-column write masking, as will become clear from the detailed description of the operation of the storage cell further below. This is particularly advantageous in performing write and computing operations (to different data sets) at the same time.

For output to a processor segment for processing the output of the storage cell, either the cell signal or the inverted cell signal may be used.

In operation of the storage cell, under application of suitable respective gating, i.e., provision of respective suitable control signals to the gates of the MOS switches, and of a suitable respective supply voltage to the branches,
- the high-keeper branch is configured to maintain the cell signal at the high bit state;
- the low-keeper branch is configured to maintain the cell signal at the low bit state;
- the force-high branch is configured to change the bit state of the cell signal from the low bit state to the high bit state; and
- the force-low branch is configured to change the bit state of the cell signal from the high bit state to the low bit state.

Regarding gating by suitable control signals in preferred embodiments, the second MOS switches of the high-keeper branch and of the low-keeper branch are gated by a write wordline signal and its complementary write wordline signal, respectively, to concurrently assume a conducting or a non-conducting state. This coupling allows maintaining the bit state of the inverted cell signal that is fed back from the inverter to the fist MOS switches of the high-keeper and the low-keeper branch if the storage cell is not selected via the write wordline signals.

For selecting or half-selecting the storage cell as a member of a given row of one or more rows of storage cells for a write operation, the second MOS switch of the high-keeper branch may be configured to assume the non-conducting state and the first MOS switch of the force-low branch is configured to assume the conducting state in response to their parallel gating by the write wordline signal. Concurrently, the second MOS switch of the low-keeper branch may be configured to assume the non-conducting state and the first MOS switch of the force-high branch is configured to assume the conducting state, in response to their gating in parallel by the complementary write wordline signal.

For selecting the storage cell in a write operation, the first MOS switch of the force-high branch may be configured to assume the conducting state in response to gating by the complementary write wordline signal; and, concurrently, the first MOS switch of the force-low branch may be configured to assume the conducting state in response to gating by the write wordline signal. For writing the high bit state to the storage cell, the second MOS-switch of the force-high branch may be configured to assume the conducting state in response to gating by a first binary value of a first bit-state control signal received via a first bit-state control line. Concurrently, the second MOS-switch of the force-low branch may be configured to assume the non-conducting state in response to gating by a first binary value of a second bit-state control signal received via a a second bit-state control line. For writing the low bit state, the second MOS-switch of the force-high branch may be configured to assume the non-conducting sate in response to gating by a complementary second binary value of first bit-state control signal; and, concurrently, the second MOS-switch of the force-low branch is configured to assume the conducting state in response to gating by a complementary second binary value of the second bit-state control signal.

Preferably, the stacked MOS switches of the high-keeper branch and of the force-high-branch are PMOS switches, and the stacked MOS switches of the low-keeper branch and of the force-low branch are NMOS switches. Instead of MOS switches of opposite conductivity type, MOS switches of the same conductivity type with inverters used in connection with those of the transistors may be used. For instance, in an NMOS technology, NMOS switches may be used throughout the storage cell, wherein inverters are connected upstream of the gates of those transistors which would be configured as PMOS switches in CMOS.

For use in memory arrays that support multiplexing between a set of storage cells in a matrix row of storage cells, a transmission gate that comprises two complementary MOS switches may be used, which receives the inverted cell signal from the inverter and further receives a pass control signal, and that is configured to either allow or block an output of the received inverted cell signal in dependence on a signal state of the received pass control signal. The pass control signal may be implemented as a set of complementary set_select signals, wherein the complementary MOS switches each receive one of the complementary set_select signals to concurrently assume their open or closed state. The storage cell of this embodiment will herein be referred to as a storage cell of the second configuration, whereas a storage cell that does not use a transmission gate at its output will be referred to as a storage cell of a first configuration.

As an alternative to the second configuration, the storage cell of a third configuration may additionally comprise a pass gate comprising a single MOS switch that receives the inverted cell signal from the inverter and further receives a pass control signal and that is configured to either allow or block an output of the received inverted cell signal in dependence on a signal state of the received pass control signal.

The storage cell of the present invention forms an advantageous elementary building block of a memory, in particular a memory for use in an in-memory processor. Such a memory forms a second aspect of the present invention. In different embodiments, the memory comprises a matrix array of storage cells according to embodiments described herein and arranged in two or more matrix rows and one or more matrix column.

The storage cell of the present invention can be implemented using a physical layout requiring a particularly small area covering the height of only one standard cell. This allows memory designs requiring only a small amount of chip real estate. In a preferred physical layout of the matrix array of storage cells for a front-end fabrication process, a gate contact is shared between a first pair of MOS switches of a given first storage cell and a second pair of neighboring MOS switches of a second storage cell, which is arranged adjacent to the first storage cell in the same matrix column of the matrix array of storage cells.

In addition to the matrix array, the memory suitably comprises at least one driver which is configured to generate and provide
- row-specific sets of the mutually complementary write-wordline signals for selecting at least one of the matrix rows for writing, and
- column-specific sets of the first and second bit-state control signals to enable or disable a change of the cell signal between a first bit state and a second bit state or vice versa in at least one selected matrix row of a respective matrix column.

In embodiments of the memory that use storage cells of the second or third configuration, the memory may further comprise
- at least one multiplexer, each multiplexer connected with a respective set of storage cells, wherein
   - the multiplexer receives the inverted cell signals from each of the storage cells of the connected set of storage cells at its multiplexer inputs, and
   - the multiplexer is configured to receive a select signal indicative of a selected one of its multiplexer inputs to be connected through to a multiplexer output and to allow an output of a selected inverted cell signal received at the selected one of its multiplexer inputs indicated by the select signal.

The multiplexer may be provided as a distributed multiplexer arrangement in the form of a set of transmission gates or pass gates in the storage cells, as in the second or third configuration, in combination with a suitable design of a driver, which is configured to generate and provide the respective pass control signals to the transmission or pass gate that open only the transmission or pass gate of the selected storage cell, while blocking the inverted cell signals of other storage cells of the given set. The driver may be shared between many multiplexers.

A third aspect of the present invention is formed by an in-memory processor, in particular for performing matrix-vector multiplication, comprising a memory according to at least one of the memory embodiments described herein. Furthermore, the in-memory processor has at least one processor segment, each processor segment being arranged in proximity and connected to
case 1: one storage cell of the first configuration, or
case 2: one of the sets of storage cells of the memory using storage cells of the second or third configuration.

Each processor segment is connected to receive a first input signal indicative of a respective input vector component value, and a second input signal formed by
case 1: the inverted cell signal from the storage cell, or
case 2: the selected inverted cell signal from the multiplexer of the associated set of storage cells,
and to determine a product of first input signal and the received inverted cell signal or selected inverted cell signal.

It is noted that in many cases, the product of interest is
{input bit x stored coefficient bit} = {AND (input bit, stored coefficient bit)}.

For practical reasons, this product can be implemented as
{NOR (inverted input bit, inverted stored coefficient bit)}

The in-memory processor preferably further comprises an accumulator connected with a group of processor segments and configured to receive the products determined by the processor segments of the group and to accumulate the received products.

Processor segments may be implemented as a 1 bit x1 bit multiplier, for instance in the form of an AND gate or of a NOR gate. In the special case of XNOR-based networks, XNOR gates can be used. It is particularly advantageous that the storage cells are capable of providing their inverted output signal at proper logic levels (vdd, vss) for driving this next stage.

A further aspect of the present invention is formed by a computer that comprises one or more memories of at least one of the second aspect or embodiments thereof, or that comprises an in-memory processor according to the third aspect of embodiments thereof.

In addition, the computer may comprise periphery devices such as input and output devices and associated controllers.

In the following, further embodiments of the invention will be described with reference to the drawings.

### BRIEF DESCRIPTION OF THE DRAWINGS

Fig. 1 is a circuit diagram of a storage cell of a first configuration according to the present invention;
Figs. 2 to 7 are illustrations for explaining the operation of the storage cell of Fig. 1 ;
Fig. 8 is an illustration of a memory with storage cells according to Fig. 1 that may be used in an in-memory processor;
Figs 9A and 9B jointly illustrate an exemplary physical layout for implementing a storage cell of Fig. 1 in a matrix array of storage cells;
Fig. 10 is an illustration of an exemplary in-memory processor for performing matrix-vector multiplication;
Fig. 11 is an illustration of an arrangement of two adjacent storage cells of a second configuration according to the present invention, which each comprise a respective output gate;
Fig. 12 is an illustration of a memory with storage cells according to Fig. 11 that may be used in an in-memory processor;
Fig. 13 is an illustration of a further exemplary in-memory processor.
Figs. 14A,14B jointly illustrate an exemplary physical layout for implementing a storage cell of Fig. 11 in a matrix array of storage cells;
Fig. 15 is a circuit diagram of a storage cell of a third configuration according to the present invention; and
Fig. 16 is an illustration of a set of storage cells of the type of the storage cell of Fig. 15, in an arrangement with a computing segment of an in-memory processor.

### DETAILED DESCRIPTION OF EMBODIMENTS

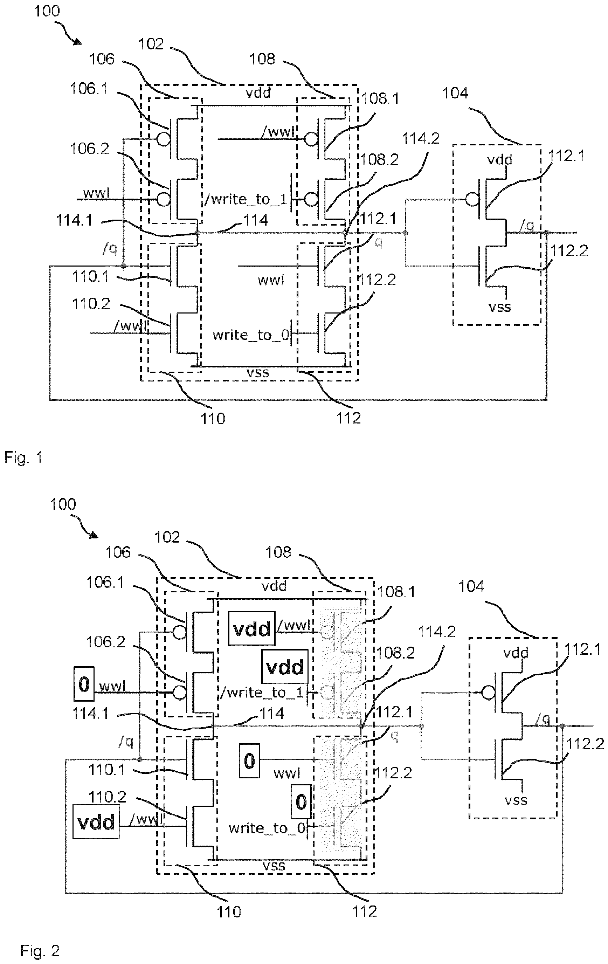

Fig. 1 is a circuit diagram of a storage cell 100 according to the present invention. The storage cell has a cell switching circuit 102 providing a cell signal q, and an inverter 104 that receives the cell signal q and provides an inverted cell signal labelled /q. The inverted cell signal /q is provided for output and fed back to the cell switching circuit 102. The cell switching circuit 102 comprises four switching branches 106, 108, 110, and 112 which are jointly operative in keeping a bit state at high or low, or in forcing a change of the bit state to high or low, as will be become clear in the following, which turns to a more detailed description of the cell switching circuit 102.

The four switching branches include a high-keeper branch 106 connected between a first supply potential mode vdd and a cell-signal node 114 at a first connection point 114.1. The first supply potential node vdd may be at a positive potential as typically used in MOS circuit. A force-high branch 108 is parallel-connected to the high-keeper branch 106 between the positive potential node vdd and a second connection point 114.2 to the cell signal node 114. A low-keeper branch 110 is connected between the cell-signal node 114 at the connection point 114.1 and a second supply potential node vss. A force-low branch 112 is parallel-connected to the low-keeper branch between the cell signal node 114 at the connection point 114.2 and the second supply potential node vss. The second supply potential node vss may be at a negative potential or at ground potential, as typically used in MOS circuits.

The cell signal q is a potential difference between the cell-signal node 114 and a second supply potential node vss.

The four switching branches 106 to 112 each comprise a pair of stacked MOS switches of equal conductivity type. Each pair includes a respective first MOS switch and a respective second MOS switch.

Regarding usage of the terms first and second MOS switch with regard to the stacked MOS switches of a given circuit branch, the term first MOS switch is used for that MOS switch of the stacked MOS switches which is arranged closer to a high potential node of the respective branch. The high potential node may be provided by the high potential level of the power supply (vdd, in the high-keeper and force-high branches) or the cell signal potential q (in the low-keeper and force-low branches). It is noted that permutations of the two MOS switches in each stack are possible.

In the present embodiment, the MOS switches 106.1, 106.2 of the high-keeper branch 106 and the MOS switches 108.1, 108.2 of the force-high branch 108 are PMOS transistors, and the MOS switches 110.1, 110.2 of the low-keeper branch 110 as well as the MOS switches 112.1, 112.2 of the force-low branch 112 are NMOS transistors. Thus, the stacked MOS switches of the high-keeper branch 106 are of a conductivity type that is opposite to that of the stacked MOS switches of the low-keeper branch 110.

The inverter 104 is a CMOS inverter circuit and comprises a PMOS transistor 104.1 having a source connected to the first supply potential node vdd, and an NMOS transistor 104.2 having a drain connected to the second supply potential node vss and a source coupled to the drain of the PMOS transistor 104.1. The two transistors 104.1 and 104.2 both receive the cell signal q at their gates.

The inverted cell signal /q is output from the inverter 104 and fed back to the gates of the first MOS switches 106.1, 110.1 of the high-keeper branch 106 and of the low-keeper branch 110, respectively. The gate of the second MOS switch 106.2 of the high-keeper branch receives a write wordline signal wwl, while the second MOS switch of the low-keeper branch is gated by an inverted write wordline signal /wwl, which is the complementary write wordline signal.

The first MOS switch 108.1 of the force-high branch is gated by the inverted write wordline signal /wwl. The second MOS switch of the force-high branch is gated by a first (inverted) bit-state control signal labelled /write_to_1 which is received via a first bit-state control line (not shown in Fig. 1). The first MOS switch 112.1 of the force-low branch 112 is gated by the write word-line signal wwl. The second MOS switch 112.2 of the force-low branch 112 is gated by a second (non-inverted) bit-state control signal labelled write_to_0 which is received via a second bit-state control line (not shown in Fig. 1).

It is noted that an alternative embodiment (not shown) may have MOS switches of the same type only, for instance only NMOS switches. In this case, inverters may be used in combination with respective NMOS switches in positions where the circuit of Fig. 1 uses PMOS switches.

It is further noted that order of the respective two MOS switches in the four branches of the storage cell is exemplary only and may be subject to permutation.

The described circuit structure and control connectivity of the storage cell 100 achieves several advantages. In particular, the output signal /q can be provided with the full voltage swing to drive a computing segment connected to the output of the storage cell. This avoids subsequent output signal amplification and provides a strong signal for the operation of compute unit. Furthermore, no signal treatment by assist techniques is required for performing the write operation. In particular, the write operation is robust and does not rely on a relative strength between the MOS switches. The same voltage supply level is used for updates of the stored value and for output of the stored cell signal. Also, the storage cell requires only a small area on a chip, which achieves a tight integration in standard cell tracks.

While the write wordline signals wwl and /wwl must be pulsed (wwl: 0 →vdd→0 in each write cycle, /wwl: vdd→0→vdd), an individual write word line has only a small capacitance, so that only a small amount of write energy is required per cell to be written. The first and second write bitline signals write_to_0 and /write_to_1 in contrast do not have to return to their de-select state between operations and thus can be "static". Since the write bitline signals dominate the write energy consumption in an array of storage cells, the structure of the storage cell 100 helps achieving strong energy savings at the array level.

Moreover, the storage cell 100 supports per-column write masking, as will become clear from the following detailed description of the operation of the storage cell 100.

In the following, thus, the operation of the storage cell 100 will be described with reference to the Figs. 2 to 7, which sometimes will be referred to in parallel. As described before, the storage cell 100 is connected to receive a set of complementary write wordline signals, wwl and /wwl, and two different sets of first and second write bitline signals, which are denoted as /write_to_1 and write_to_0. These write bitline signals can each assume a high or low signal level, corresponding in voltage to vdd and vss or ground (denoted as 0), respectively.

Figs. 2 to 7 show the applied signal levels that are set in operation to let the storage cell 100 assume a desired state in a desired write operation, as will be explained in the following. It has to be kept in mind that in typical application cases the storage cell will be arranged in a matrix arrangement, in which a plurality of individual storage cells of the kind shown in Fig. 1 are connected along rows and columns. An individual cell can be addressed as a member of a row by the settings of the write wordline signals and as a member of a column by the write bitline signals, as described in the following. In Figs. 2 to 7, MOS switches set to an open (non-conducting) state by a given signal setting are greyed out.

Fig. 2 illustrates a first signal setting, by which both the row of the storage cell 100 and the column of the storage cell 100 are deselected by the signal levels indicated. In particular, the write wordline signal wwl is set to 0 and the complementary write wordline signal /wwl is set to vdd. This lets the MOS switch 106.2 of the high-keeper branch 106 and the MOS 110.2 of the low-keeper branch 110 assume their closed (conducting) state, and the MOS switch 108.1 of the force-high branch 108 and the MOS switch 112.1 of the force-low branch 112 assume their open (non-conducting) state. Since the column of the storage cell is also deselected, the first write bitline signal write_to_0, which is set to 0 (vss or GND), lets MOS switch 112.2 of the force-low branch 112 assume its open state, and the second write bitline signal /write_to_1 is set to vdd to let MOS switch 108.2 of the force-high branch assume its open state. The given signal setting of the complementary write wordline signals wwl and /wwl puts the high-keeper branch 106 and the low-keeper branch in mutually opposite switching states, depending on the currently assumed cell signal level q, which determines the states of the MOS switches 106.1 of the high-keeper branch 106 and 110.1 of the low-keeper branch 110. This results in the currently assumed cell signal state of the cell signal node 114 being maintained. For the given control signal setting the storage cell 100 thus behaves like a proper cross-coupled storage latch.

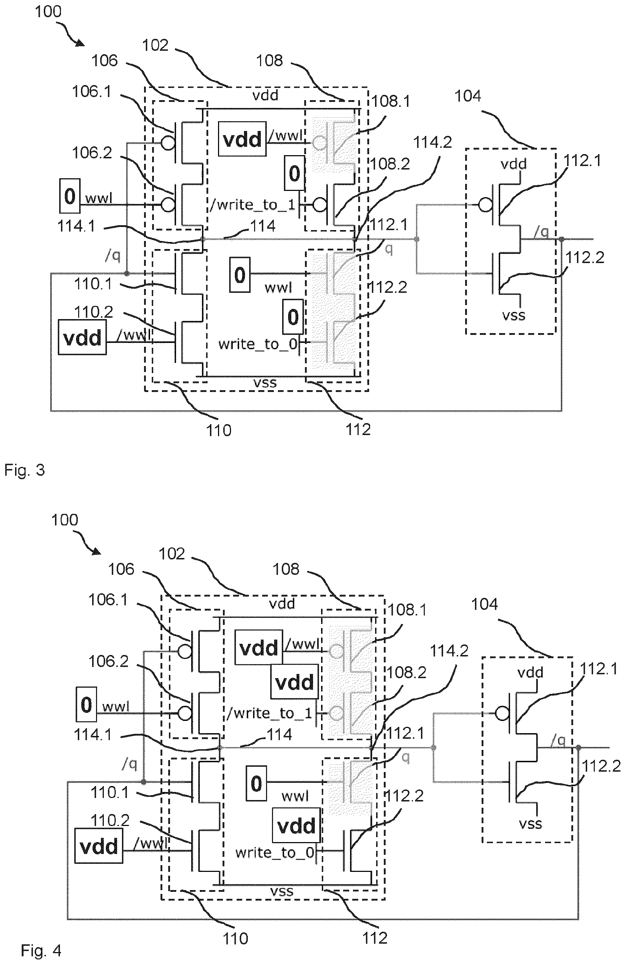

Fig. 3 illustrates a second signal setting, by which the row of the storage cell 100 is deselected and the the storage cell 100 is half-selected in its column for a "write to 1" operation by the signal levels indicated. Half-selection of a storage cell in a column means that the storage cell 100 is not selected for a write operation, but one or more other storage cells of the same column of storage cells are selected. Thus, the write wordline signals are the same as in the setting of Fig. 2 and deselect the given row of storage cells. Also, the first write bitline signal write_to_0 is the same as in Fig. 2 and deselects the column for a "write to 0" operation, but the second write bitline signal /write_to_1 has changed to assume the signal level 0 for selection of the column for the "write to 1" operation. This puts the MOS switch 108.2 of the force-high-branch to its closed (conducting) state, while the MOS switches of the force-low branch 112 and the MOS switch 108.1 of the force-high branch 108 are in their open (non-conducting) state. This in turn does not have a significant influence on the cell signal node 114 of the storage cell 100, which thus maintains its previous value.

Fig. 4 illustrates a third signal setting, by which the row of the storage cell 100 is deselected and the storage cell 100 is half-selected in its column for a "write to 0" operation by the signal levels indicated. Thus, the write wordline signals are the same as in the setting of Fig. 2 and 3 to deselect the given row of storage cells. The first write bitline signal write_to_0 is changed in comparison with Figs. 2 and 3 and selects the column for a "write to 0" operation, while the second write bitline signal /write_to_1 assumes the signal level vdd for deselection of the column for the "write to 1" operation, as in Fig. 2. This setting puts the MOS switch 112.2 of the force-low-branch to its closed (conducting) state, which the MOS switches of the force-high branch 108 and the MOS switch 112.1 of the force-low branch are in their open (non-conducting) state. This in turn does not have an influence on the cell signal node 114 of the storage cell 100, which thus maintains its previously assumed value.

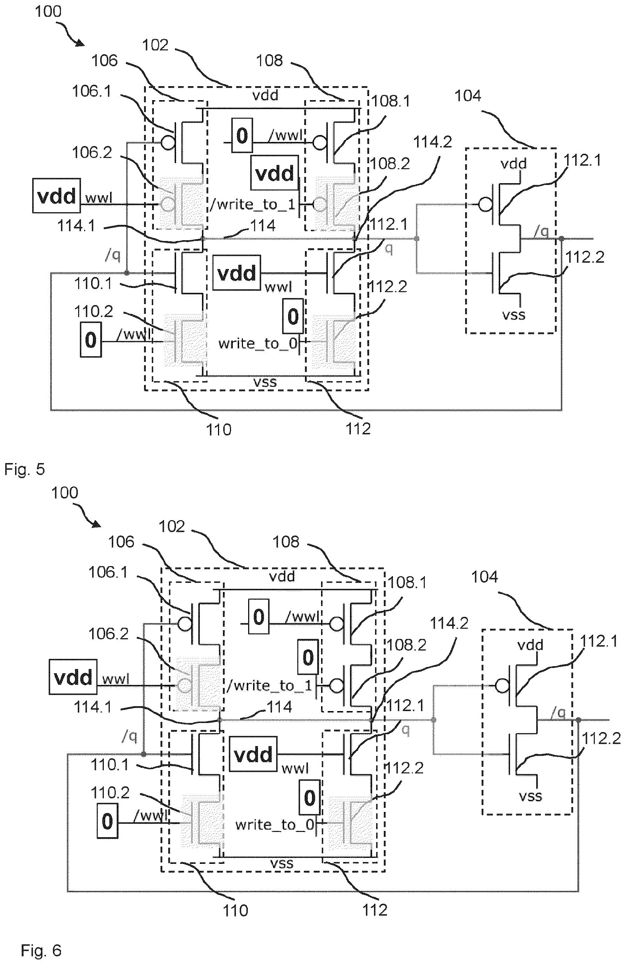

Fig. 5 illustrates a fourth signal setting, by which the storage cell 100 is half-selected in its row while being deselected in its column operation by the signal levels indicated. Thus, the write wordline signals are changed in comparison with the settings of Fig. 2 to 4 to select the given row of storage cells. In particular, the MOS switches 106.2 of the high-keeper branch 106 and 110.2 of the low-keeper branch 110 assume their open (non-conducting) state. The signal levels of both write bitline signals deselect the column of the storage cell 100. Therefore, the signal level of the cell signal node 114 is left floating at its previously assumed value, given a suitable duration of the wwl pulse, which should be selected not too long. This signal setting allows a per-column write masking using desired values for the write bitline signals write_to_0 and /write_to_1. With the setting shown in Fig. 5, no writing operation is performed in the column of the storage cell 100.

Fig. 6 illustrates a fifth signal setting, by which the storage cell 100 is selected for a "write to 1" operation by the signal levels indicated. The write wordline signals are the same as in the setting of Fig. 5 and select the given row of storage cells that includes the storage cell 100. The first write bitline signal write_to_0 is set to 0 to open the MOS switch 112.2 in the force-low branch, while the second write bitline signal /write_to_1 assumes the signal level 0 for selection of the column for the "write to 1" operation. This setting puts both MOS switches 108.1 and 108.2 of the force-high branch to their closed (conducting) state, thus pulling the cell signal node 114 to the high (vdd) level, forcing the signal level of the cell signal q to its high bit state. This write operation is not opposed by the low-keeper branch, as transistor 110.2 is in a non-conducting state due to the state of /wwl.

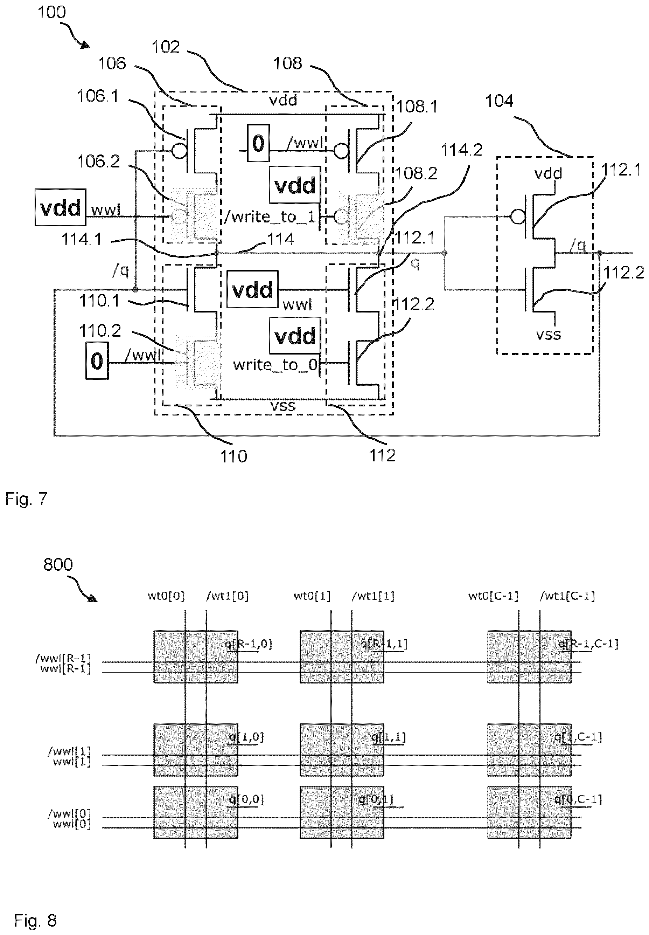

Fig. 7 illustrates a sixth signal setting, by which the storage cell 100 is selected for a "write to 0" operation by the signal levels indicated. The write wordline signals are the same as in the setting of Fig. 6 and select the given row of storage cells that includes the storage cell 100. The first write bitline signal write_to_0 is set to vdd to close the MOS switch 112.2 in the force-low branch, while the second write bitline signal /write_to_1 assumes the signal level vdd for deselection of the column for the "write to 1" operation by opening MOS switch 108.2. This setting puts both MOS switches 112.1 and 112.2 of the force-low branch to their closed (conducting) state, thus pulling the cell signal node 114 to the low (vss, gnd) level, so that the signal level of the cell signal q is forced to its low bit state. This write operation is not opposed by the high-keeper branch, as transistor 106.2 is in a non-conducting state due to the state of wwl.

From the above, the write wordline signal and its complementary write wordline signal are thus used to concurrently let the second MOS switches of the high-keeper branch and of the low-keeper branch assume a conducting or a non-conducting state.

Fig. 8 is an illustration of a memory 800 that may be used in an in-memory processor. The memory comprises a matrix array of storage cells (indicated schematically only by grey boxes) of the type of the storage cell 100 shown in Figs. 1 to 7, which are arranged in a number R of matrix rows (counting from bottom to top) and a number C of matrix columns (counting from left to right). Also shown are write wordlines wwl [r] and complementary write wordlines /wwl [r] for each matrix row numbered r (r=0,1,2,...R-1) of storage cells, and write bitlines wt0 [c] and /wt1 [c] for each matrix column numbered c (c=0,1,2,...C-1). The connections of the write wordlines, complementary write wordlines, and of the write bitlines to each individual storage cell are as explained in the context of the Figs 1 to 7. Each storage cell provides a cell state signal q[r,c]. In a write operation, the write wordline wwl [r] selects one row r of storage cells for writing. In a write operation for a given row, there are two options: write all cells on this row, or write only a subset of the cells on this row. The latter may be achieved by masking a part of the columns, which is achieved by setting wt0[c]=0 and /wt1[c]=1 (wt1[i]=0) for the columns c to be masked. Masking may be employed to reduce an external IO bus width similar to a SRAM mux factor or to reduce energy consumption if not all weights have to be updated, for instance in an in-memory computing array that is only partially used.

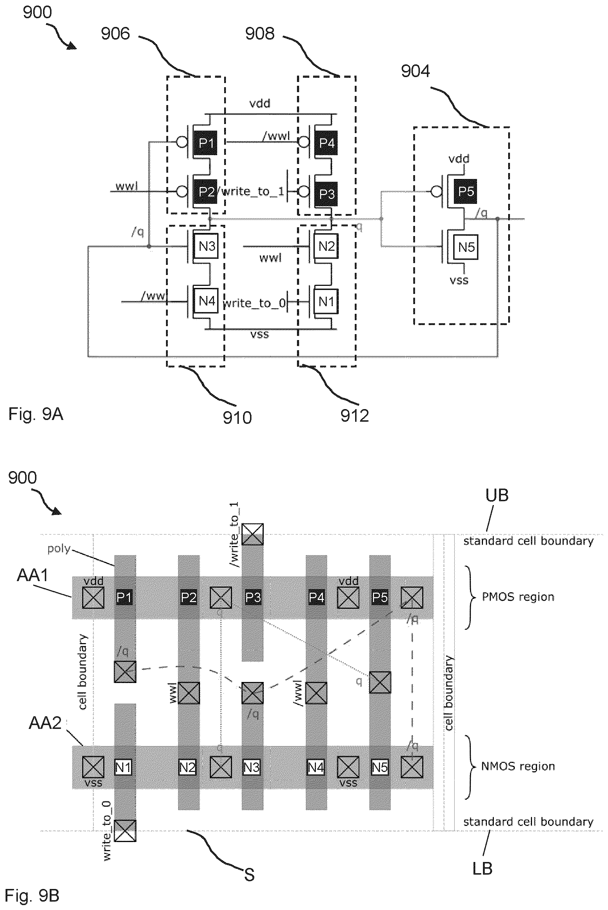

Figs 9A and 9B jointly illustrate an exemplary physical layout for implementing a storage cell 900 in a matrix array of storage cells in a CMOS front-end technology. Both figures will be referred to in parallel in the following. The storage cell 900 shown in the circuit diagram of Fig. 9A corresponds to the storage cell 100 of Fig. 1, but has a different labelling for easier comparison with the physical layout shown schematically in a plan view in Fig. 9B.

The physical layout of the storage cell 900 is designed to fit into the area of a standard cell S, which in the present example is standard cell of a 12 nm CMOS technology node. Adaptations may be required when using other technology nodes. Boundaries of the standard cell are indicated by a dashed line. An NMOS silicon region is provided in the lower half of the standard cell, and a PMOS silicon region is provided in the upper half. The NMOS region comprises the NMOS transistors N1 to N5 of the low-keeper branch 910, the force-low-branch 912, and of the inverter 904. The PMOS region comprises the PMOS transistors P1 to P5 of the high-keeper branch 906, the force-high branch 908, and of the inverter 904.

Five poly lines for contacting the gates of the transistors run vertically, which in the present context refers to a direction on the paper plane from the upper boundary UB to the lower boundary LB of the standard cell and perpendicular to the boundary lines. They poly lines are interrupted between the transistors of the PMOS and NMOS regions, except where the circuit requires their connection, namely, except for P2 and N2, which both receive the write wordline signal wwl, for P4 and N4, which both receive the complementary write wordline signal /wwl, and except for P5 and N5, which both receive the cell signal q. Two strips of an active silicon area extending horizontally across the standard cell S are indicated by reference labels AA1 and AA2 . Transistor gates of the transistors P1 to P5 and N1 to N5 are formed at the respective crossings of the active area strips with the poly.

Notably, gate contacts that are common to the given matrix column are shared along the standard cell boundaries UB and LB. Specifically, at the upper standard cell boundary UB the gate contact of the PMOS transistor P3, which receives the /write_to_1 signal, is shared with a PMOS transistor of a second storage cell (not shown), which is arranged adjacent to the storage cell 900 in the same matrix column of the matrix array of storage cells. Similarly, at the lower standard cell boundary LB, the gate contact of the NMOS transistor N1 is shared with an NMOS transistor of a second storage cell (not shown), which is arranged adjacent to the storage cell 900 in the opposite direction, again in the same matrix column.

From the above description, it becomes clear that for saving chip real estate the transistor ordering in the physical layout is modified in comparison with the circuit diagram so that each poly slot has either NMOS and PMOS with identical gate signal, or NMOS with a 'unique' gate connection and PMOS sharing a gate connection with neighboring cell, or PMOS with a 'unique' gate connection and NMOS sharing gate connection with neighboring cell. This way, it is achieved that the arrangement fits in an area of 1 standard cell track height x 5.5 poly pitches (PP).

The arrangement may be modified to achieve an equivalent saving of chip real estate. Specifically, the first two polys from the left may be swapped, or the third and fourth poly may be swapped. Or the pair of the first two polys from the left may be swapped with the pair of the third and fourth poly from the left.

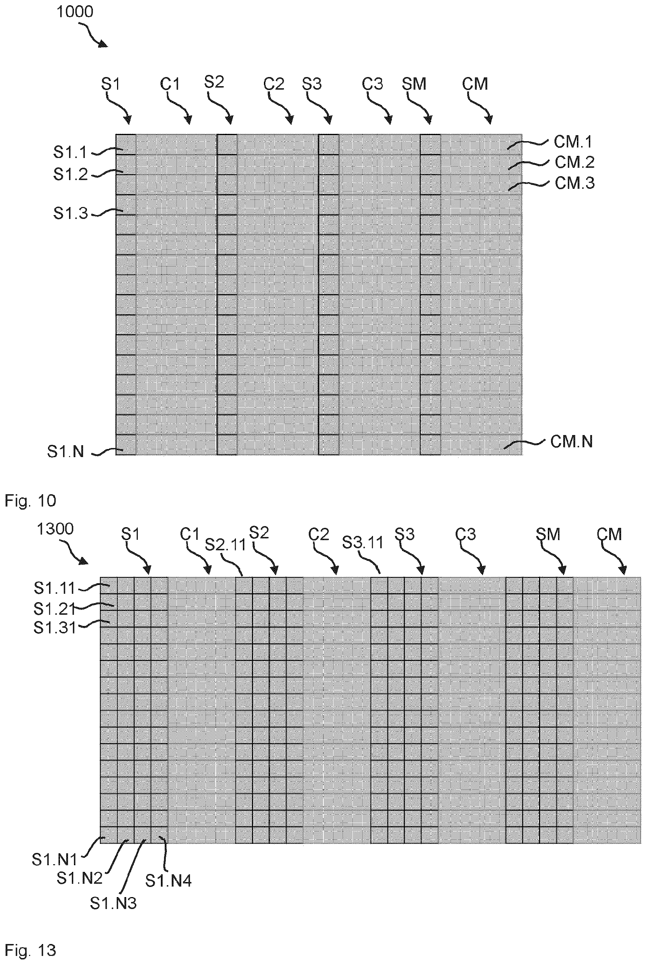

Fig. 10 is an illustration of an exemplary in-memory processor 1000 for performing matrix-vector multiplication. The in-memory processor 1000 comprises an alternating sequence of M storage-cell columns S1, S2, S3,..., SM and M processor-segment columns C1, C2, C3, ...CM, wherein M is an integer. Each storage cell column has a column width of one storage cell and a column of N storage cells, wherein N is an integer. As an example, processing segments CM.1, CM.2, CM.3, and CM.N in the Mth column are labelled accordingly. The storage cells may be of the type of the storage cell 900 shown in Fig. 9, or any other suitable physical implementation of the storage cell of Fig. 1. The storage cells of the left-most storage-cell column S are labelled S1.1 to S1.N. The storage cells provide their respective inverted cell signal as an output to the respective adjacent processor segment to the right, such that the computing cells of the processor-segment column C1 receive their input from the storage cells S1.1 to SN.1 of the storage-cell column S1, etc. Respective data and control input lines to the processor segments and to the storage cells and respective output lines are not shown for simplicity of graphical representation.

In operation of the in-memory processor 1000 for performing a vector-matrix multiplication, a given processor segment receives input factors formed by a weight coefficient bit value that is the inverted cell signal of the adjacent storage cell, and by an input vector component bit value from a data source that may be external to the in-memory processor 1000. The same input bit value would normally be provided to many processor segments on a row. The processor segment performs a multiplication of the received input bit values and provides the determined product bit value as an output for further processing. It is noted that the processor segments may be implemented as a 1 bit x1 bit multiplier in the form of an AND gate or of a NOR gate in normal networks, or in the form of an XNOR gate in XNOR networks. It is particularly advantageous that the storage cells are capable of providing their inverted output signal at proper logic levels (vdd, vss) for driving this next stage.

With a ratio of 1 storage cell per 1 processor segment, the in-memory processor 1000 achieves a particularly high computation throughput density (as measured in operations per second per unit area, typically expressed as Tera Operations Per Second per square millimeter (TOPS/mm²). On the other hand, it features a low weight storage density (as measured in weight matrix coefficients stored per unit area). The energy efficiency of the in-memory processor 1000 (as measured in TOPS/W) is particularly good.

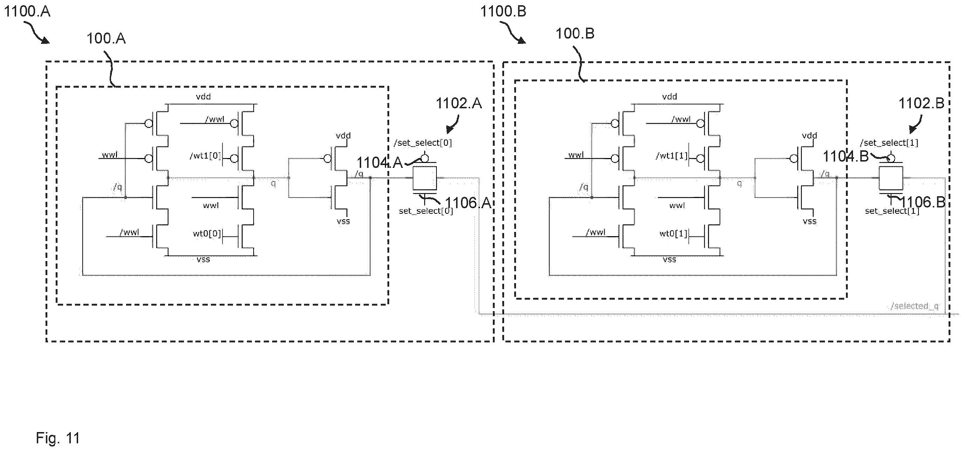

Fig. 11 is an illustration of an arrangement of two adjacent storage cells 1100.A and 1100.B, which in addition to a storage cell circuit of the type of the storage cell 100 shown in Figs. 1 to 7 (labelled 100.A and 100.B) each comprise a respective output gate segment formed by a CMOS transmission gate 1102.A and 1102.B. The CMOS transmission gates 1102.A and 1102.B each comprise a transistor pair formed by a PMOS transistor 1104.A, 1104.B and an NMOS transistor 1106.A, 1106.B connected in parallel. The transistors are gated by pass control signals, which are implemented as mutually complementary set_select control signals that are provided for each storage cell individually. In operation, while the set_select control signal is LOW and the complementary set_select control signal /set_select is HIGH, both the NMOS and PMOS transistors are in their open state and block output of the inverted cell signal /q of the respective storage cell. Moreover, while the set_select control signal is HIGH and the complementary set_select control signal /set_select is LOW, both the NMOS and PMOS transistors are in their closed state conduct the inverted cell signal /q of the respective storage cell via their source-drain path.

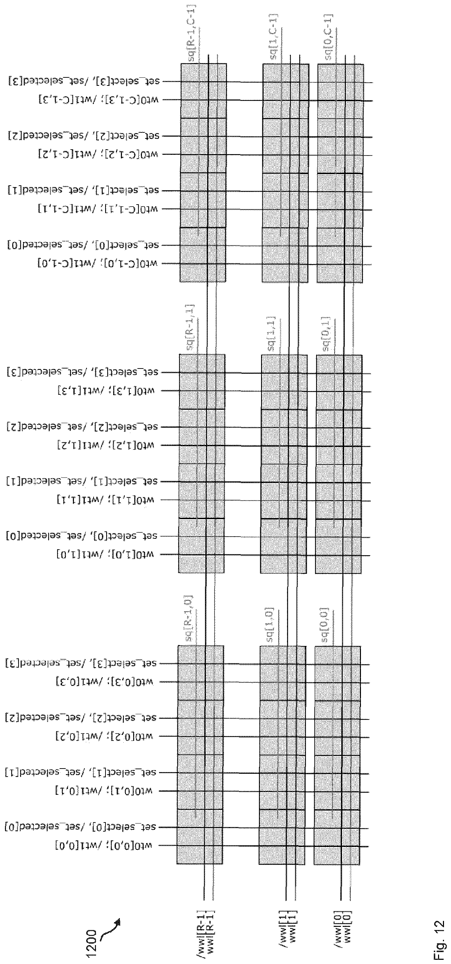

The arrangement shown in Fig. 11 can be extended in other embodiments by adding one or more storage cells of the kind 1100.A and 1100.B, thus continuing in the series connection of the storage cells 1100.A and 1100.B. While the storage and write operation are identical to that described for the storage cell 100, the output of the storage cells 1100.A and 1100.B may be multiplexed using the transmission gates 1102.Aand 1102.B. This will be explained in the following with additional reference to Fig. 12.

Fig. 12 is an illustration of a memory 1200 that may be used in an in-memory processor. The memory comprises a matrix array of storage cells. The storage cells are the type of the storage cell 1100.A, 1100.B shown in Fig. 11 and are arranged in a number R of matrix rows (counting from bottom to top) and a number C of matrix columns (counting from left to right). Sets of four storage cells (indicated schematically by grey boxes) are interconnected by a common output in respective sections of a matrix row. Multiplexing in the output is controlled by a set of complementary set_select control signal lines set_select[sc], /set_selected[sc], for each of the four subcolumns sc= 0, 1, 2, 3. All storage cells in a given subcolumn of the matrix array are controlled by the same pair of complementary set_select control signals. Also shown are write wordlines wwl [r] and complementary write wordlines /wwl [r] for each matrix row numbered r (r=0,1,2,...R-1) of storage cells. Furthermore, write bitlines wt0[c, sc] and /wt1[c, sc] are provided for each matrix column numbered c (c=0,1,2,...C-1) and each matrix subcolumn sc, sc=0,1,2,3. The connections of the write wordlines, complementary write wordlines, and of the write bitlines to each individual storage cell are as explained in the context of the Figs 1 to 7. The connections of the set_select control signal lines set_select[sc], /set_selected[sc] are as explained in the context of the Fig. 11. Each set of four storage cells provides a selected inverted cell signal sq[r,c].

In a write operation for overwriting a matrix, the write wordline wwl [r] selects one row r of storage cells for writing and the write bitline signals wt0[c, sc] and /wt1[c, sc] are chosen to select corresponding subcolumns of the sets of storage cells in the given row for writing. As explained for the memory of Fig. 8, the design of storage cells in the memory 1200 supports per-column write masking. Read operations are multiplexer-controlled using the complementary set_select control signal lines for selecting one storage cell of a set of four storage cells for providing its output.

Fig. 13 is an illustration of an exemplary in-memory processor 1300 for performing matrix-vector multiplication. Like the in-memory-processor 1000 of Fig. 10, the in-memory processor 1200 comprises an alternating sequence of M storage-cell columns S1, S2, S3,..., SM and M processor-segment columns C1, C2, C3, ...CM, wherein M is an integer. However, in the present embodiment, each storage cell column has a column width of four storage cells, thus exhibiting a structure of sub-columns in the storage-cell columns. The memory component of the in-memory processor 1300 thus generally corresponds in structure to the memory 1200 shown in Fig. 12. For illustrating the systematics of the arrangement and distribution of the storage-cell columns and processor-segment columns of the in-memory processor 1300, in the first storage-cell column S1, the first storage cells S1.11, S2.11, S3.11 of the first, second and third storage-cell rows are labelled (each of these thus being arranged in the first sub-column), and in the Nth storage-cell row of the first storage-cell column S1 all four storage cells S1.N1, S1.N2, S1.N3 and S1.N4 are labelled (each of these thus being arranged in a different subcolumn). The individual storage cells are of the type of the storage cell 1100.A or 1100.B shown in Fig. 11 and connected as shown there. Again, data and control input lines to the processor segments and to the storage cells and respective output lines are not shown for simplicity of graphical representation.

In comparison with the in-memory processor 1000 of Fig. 10, the in-memory processor 1300 achieves a higher density of stored matrix coefficients per unit area, at the cost of a lower computation throughput density (in TOPS/mm²) and a slightly lower energy efficiency (in TOPS/W).

In operation, any of the the storage cells of a given row in a storage-cell column may provide their respective inverted cell signal as an output to the respective adjacent processor segment to the right, depending on the complementary set_select control signals that are provided to the transmission gate of each storage cell. Suitably, in particular for vector-matrix multiplication operations, the complementary set_select control signals select storage cells of a single sub-column at a given time. However, there is no technical limitation to this mode of operation. In comparison with the in-memory processor of Fig. 10, by switching the complementary set_select control signals to select from a different sub-column in the next multiplication operation, it is for instance possible to immediately switch in the processing of incoming input data between different pre-stored weight matrix configurations, without having to first write a different matrix configuration to the memory of the in-memory processor. This accelerates the processing in such application cases. It is noted that the bitline write signals write_to_0 and /write_to_1 can be static. They do not have to return to their de-select state between operations. Since these lines dominate the write energy consumption at array level, this allows achieving a particularly low consumption of energy.

Also the read line carrying the inverted selected cell signal (7selected_q") can be static, i.e., there is no need for a precharge/evaluate scheme as in SRAM memories. As explained previously, the storage cells are capable of providing a full-swing output signal to the processing segments. This achieves robust operation without need of signal conditioning in terms of additional periphery for read operations, e.g. a sense amplifier, and allows limiting the usage of chip real estate for an in-memory processor to a small area.

The configuration of the in-memory processor 1200 may be modified to include an even higher number of storage cell sub-columns per storage-cell column. For instance, an 8:1, 16:1 or even 32:1 ratio of storage cells per processing segment may be implemented.

Advantageous usage of sub-columns is enabled by the capability of performing column bit-masking, as explained in the context of the description of Figs. 1 to 7. For instance, it is possible to write to one of the sub-columns in parallel with reading from another for processing, which uses the value of the signal /selected_q. This achieves particularly fast and efficient operation of the in-memory processor because coefficients can be updated without causing stalling the processing operation.

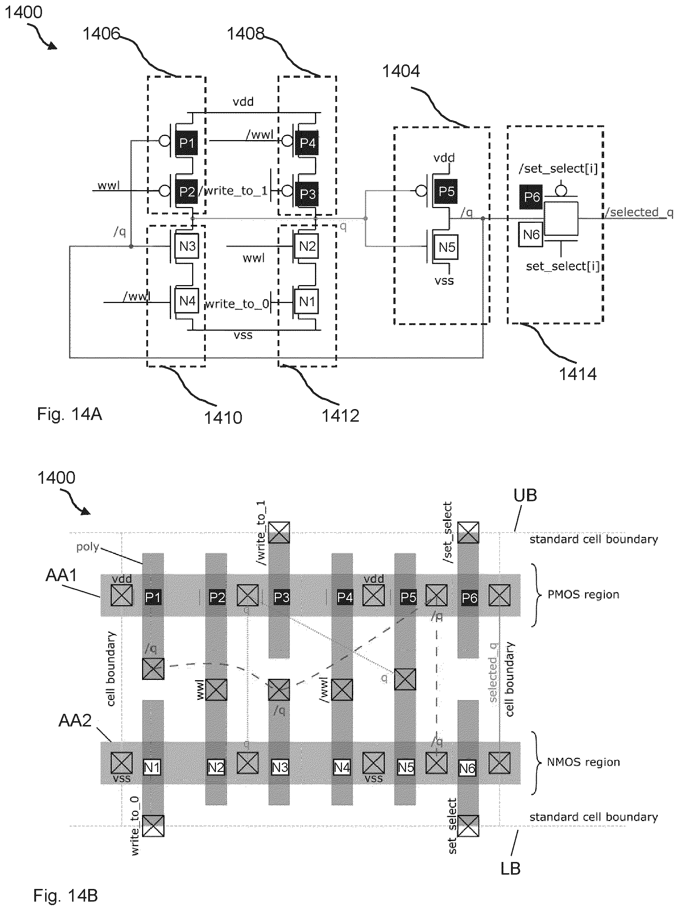

The storage cell of Fig. 11 also allows tight integration in standard cell tracks with use of a small chip area of one standard cell track in height and 6 poly pitches in width. There is no need for gaps with neighboring standard cells (e.g. NOR gates, full adder cells, etc. ). This will be shown in the following with additional reference to Figs 14A and 14B, which jointly illustrate an exemplary physical layout for implementing a storage cell 1400 in a matrix array of storage cells in a CMOS technology. Both figures will be referred to in parallel in the following. The storage cell 1400 shown in the circuit diagram of Fig. 14A corresponds to the storage cell 1100.A of Fig. 11, but has a different labelling for easier comparison with the physical layout shown schematically in a plan view in Fig. 14B. The labelling is chosen in correspondence to the illustrations of Figs. 9A and 9B, only differing in the prefix 14 in the reference labels of the inverter 1404, high-keeper branch 1406, the low-keeper branch 1410, the force-high branch 1408, the force-low branch 1412. In addition the CMOS transmission gate is shown under reference label 1414. In fact, the physical layout of the storage cell 1400 largely corresponds to that of the storage cell 900. In particular, for an explanation of the arrangement and connections of the transistors N1 to N5 and P1 to P5, reference is made to the description of Figs. 9A and 9B. Due to the addition of the CMOS transmission gate 1414, additional transistors N6 and P6 are provided in the standard cell, which in the present case thus has a width of 6 poly pitches. The complementary set_select signals are shared between the illustrated cell and respective cells in adjacent rows. Thus, also the storage cell 1100.A is designed to fit into the area of a standard cell S.

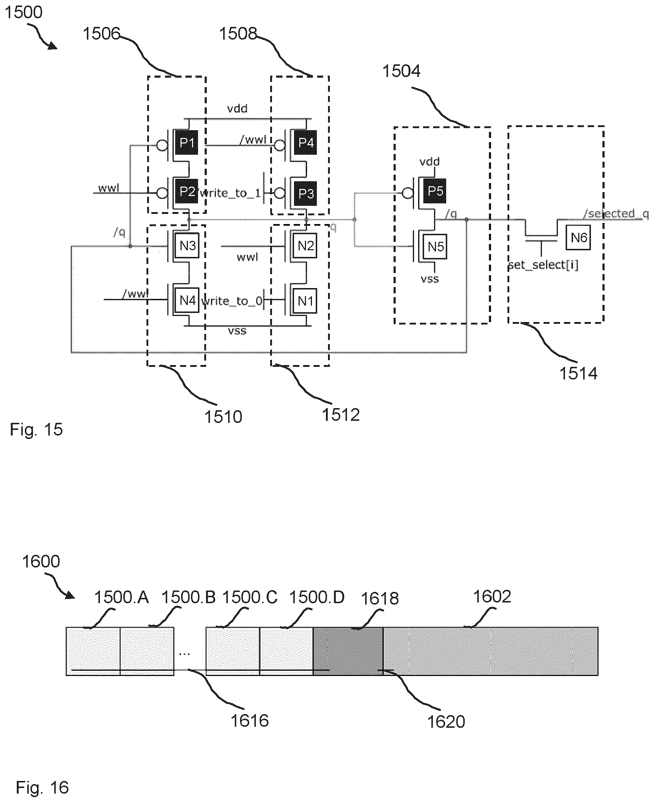

Fig. 15 is a circuit diagram of a further embodiment of a storage cell 1500. The circuit diagram of the storage cell 1500 largely corresponds to that of the storage cell 1400 of Fig. 14. Therefore, the labelling in Fig. 15 is chosen in correspondence to the illustrations of Fig. 14, only differing in the prefix 15 in the reference labels of the inverter 1504, high-keeper branch 1506, the low-keeper branch 1510, the force-high branch 1508, the force-low branch 1512. Instead of the CMOS transmission gate 1414 used in the embodiment of Fig. 14, the storage cell 1500 has a pass gate shown under reference label 1514 and formed by a single NMOS transistor. Only a pass control signal in the form of a single set_select signal is therefore required, which in a set of storage cells is shared between the illustrated cell and respective adjacent cells. In an alternative embodiment (not shown), the pass gate is formed by a single PMOS transistor.

Fig. 16 is an illustration of a set of storage cells of the type of the storage cell 1500, and therefore labelled 1500.A to 1500.D, connected to provide a multiplexed output of a selected inverted cell signal /selected q to a computing segment 1602. Since the storage cell 1500 has a simple pass gate instead of the transmission gate of the storage cell 1400 of Fig. 14, a read bitline(s) 1616 for providing the respective inverted cell signals will only exhibit a partial voltage swing. Therefore, an amplifier and latch 1618 is added at the end of the read bitline 1616 to maintain a full-level static output signal to feed to the computing segment 1602. The design of the storage cell 1500 achieves a lower capacitance on the read bit line which reduces the control energy amount required for a switching operation of the pass gate in comparison with a CMOS transmission gate.

In summary, a storage cell for storing a binary cell signal comprises a high-keeper branch connected between a first supply potential and a cell-signal node; a force-high branch that is parallel-connected to the high-keeper branch; a low-keeper branch that is connected between the cell-signal node and a second supply potential, and a force-low branch that is parallel-connected to the low-keeper branch. These switching branches each comprise stacked MOS switches of equal conductivity type. The stacked MOS switches of the high-keeper branch are of a conductivity type that is opposite to that of those of the low-keeper branch. The cell-signal is tapped as a potential difference between the cell-signal node and the second supply potential. An inverted cell signal is fed back from an inverter to gate the first MOS switches of the high-keeper branch and of the low-keeper branch in parallel.

## Claims

1. A storage cell (100) for storing a high or low bit state of a binary cell signal, the storage cell comprising
- a cell switching circuit (102) providing the cell signal (q), and an inverter (104) that receives the cell signal and provides an inverted cell signal (/q), wherein the cell switching circuit (102) comprises the following switching branches jointly operative in keeping the bit state at high or low or in forcing a change of the bit state to high or low:
a high-keeper branch (106) connected between a first supply potential (vdd) and a cell-signal node (114.1; 114.2);
a force-high branch (108) that is parallel-connected to the high-keeper branch (106);
a low-keeper branch (110) that is connected between the cell-signal node (114.1; 114.2) and a second supply potential (vss), and
a force-low branch (112) that is parallel-connected to the low-keeper branch (110); wherein
- the switching branches each comprise stacked MOS switches (106.1, 106.2) of equal conductivity type including a respective first MOS switch (106.1) and a respective second MOS switch (106.2), wherein the stacked MOS switches of the high-keeper branch (106) are of a conductivity type that is opposite to that of the stacked MOS switches (110.1, 110.2) of the low-keeper branch (110);
- the cell-signal (q) is tapped as a potential difference between the cell-signal node (114.1, 114.2) and the second supply potential (vss); and wherein
- the inverted cell signal (/q) is fed back from the inverter (104) to gate the first MOS switches (106.1, 110.1) of the high-keeper branch (106) and of the low-keeper branch (110) in parallel.

2. The storage cell of claim 1, wherein
- the second MOS switches (106.2, 110.2) of the high-keeper branch (106) and of the low-keeper branch (110) are gated by a write wordline signal (wwl) and its complementary write wordline signal (/wwl), respectively, to concurrently assume a conducting or a non-conducting state.

3. The storage cell of claim 2, wherein, for selecting or half-selecting the storage cell as a member of a given row of one or more rows of storage cells for a write operation,
the second MOS switch (106.2) of the high-keeper branch (106) is configured to assume the non-conducting state and the first MOS switch (112.1) of the force-low branch is configured to assume the conducting state in response to their parallel gating by the write wordline signal (wwl); and, concurrently,
the second MOS (110.2) switch of the low-keeper branch (110) is configured to assume the non-conducting state and the first MOS switch (108.1) of the force-high branch (108) is configured to assume the conducting state, in response to their gating in parallel by the complementary write wordline signal (/wwl).

4. The storage cell of claim 2 or 3, wherein, for selecting the storage cell in a write operation,
the first MOS switch (108.1) of the force-high branch (108) is configured to assume the conducting state in response to gating by the complementary write word-line signal (/wwl); and, concurrently,
the first MOS switch (112.1) of the force-low branch is configured to assume the conducting state in response to gating by the write wordline signal (wwl).

5. The storage cell of claim 4, wherein,
for writing the high bit state,
the second MOS-switch (108.2) of the force-high branch (108) is configured to assume the conducting state in response to gating by a first binary value of a first bit-state control signal (/write_to_1) received via a first bit-state control line; and, concurrently,
the second MOS-switch (112.2) of the force-low branch (112) is configured to assume the non-conducting sate in response to gating by a first binary value of a second bit-state control signal (write_to_0) received via a a second bit-state control line; and,
for writing the low bit state,
the second MOS-switch (108.2) of the force-high branch (108) is configured to assume the non-conducting sate in response to gating by a complementary second binary value of the first bit-state control signal (/write_to_1); and, concurrently,
the second MOS-switch (112.2) of the force-low branch (112) is configured to assume the conducting state in response to gating by a complementary second binary value of the second bit-state control signal (/write_to_0).

6. The storage cell of any of the preceding claims, wherein
- the stacked MOS switches of the high-keeper branch (106) and of the force-high-branch (108) are PMOS switches;
- the stacked MOS switches of the low-keeper branch (110) and of the force-low branch (112) are NMOS switches.

7. The storage cell (1100.A) of at least one of the claims 1 to 6, additionally comprising
- a transmission gate (1102.A) that comprises two complementary MOS switches (1104.A, 1106.A) and that receives the inverted cell signal (/q) from the inverter and further receives a pass control signal (set_select[0], /set_select [0]), and that is configured to either allow or block an output of the received inverted cell signal (/q) in dependence on a signal state of the received pass control signal.

8. The storage cell (1500) of at least one of the preceding claims, additionally comprising
- a pass gate (1514) comprising a single MOS switch (N6) that receives the inverted cell signal (/q) from the inverter (1504) and further receives a pass control signal (set_select[i]) and that is configured to either allow or block an output of the received inverted cell signal (/q) in dependence on a signal state of the received pass control signal.

9. A memory (1200, S1) for use in an in-memory processor (1000, 1300) , the memory comprising
- a matrix array of storage cells (S1.1, S1.2, S1.3, S1.N; S1.11, S1.21, S1.31, S1.N1) according to at least one of the claims 1 to 8 arranged in two or more matrix rows and one or more matrix column.

10. The memory of claim 9, wherein, in a physical front-end layout of the matrix array of storage cells, a gate contact is shared between a first pair of MOS switches (N1, P3) of a given first storage cell (900), and a second pair of neighboring MOS switches of a second storage cell, which is arranged adjacent to the given first storage cell in the same matrix column of the matrix array of storage cells.

11. The memory of claim 9 or 10, wherein
- the matrix array comprises storage cells (S1.1, S1.2, S1.3, S1.N; S1.11, S1.21, S1.31, S1.N1) according to claim 5 or to claims 5 and 6; and wherein
- at least one driver is configured to generate and provide
- row-specific sets of the mutually complementary write-wordline signals (wwl [0], /wwl[0]) for selecting at least one of the matrix rows for writing, and
- column-specific sets of the first and second bit-state control signals (wt0[0,0], /wt1[0,0]) to enable or disable a change of the cell signal (q[0,0]) between a first bit state and a second bit state or vice versa in at least one selected matrix row of a respective matrix column.

12. The memory of at least one of the claims 9 to 11, wherein the matrix array comprises
- at least one multiplexer (1102A, 1102B), each multiplexer connected with a respective set of storage cells (100.A, 100.B), wherein
- the multiplexer receives the inverted cell signals (/q) from each of the storage cells of the connected set of storage cells at its multiplexer inputs; and
- the multiplexer is configured to receive a select signal (set_select[0], set_select[1]) indicative of a selected one of its multiplexer inputs to be connected through to a multiplexer output and to allow an output of a selected inverted cell signal (/q) received at the selected one of its multiplexer inputs indicated by the select signal.

13. The memory of claims 11 and 12, wherein the driver is further configured to generate and provide the respective select signal to the at least one multiplexer (1102A, 1102B).

14. An in-memory processor (1000, 1300), in particular for performing matrix-vector multiplication, comprising
- a memory according (S1, S2, S3, SM) to at least one of the claims 9 to 13;
- at least one processor segment (CM.1, CM.2, C3, CM.3), each processor segment being arranged in proximity and connected to
case 1: one storage cell (S1.1), or
case 2: one of the sets of storage cells (S1.1, S1.2, S1.3, S1.N; S1.11, S1.21, S1.31, S1.N1) of the memory (S1) according to claim 11; wherein
- each processor segment is connected to receive a first input signal indicative of a respective input vector component value, and a second input signal formed by
case 1: the inverted cell signal (/q) from the storage cell, or
case 2: the selected inverted cell signal (/q) from the multiplexer of the associated set of storage cells,
and to determine a product of first input signal and the received inverted cell signal or selected inverted cell signal; and comprising
- an accumulator connected with a group of processor segments and configured to receive the products determined by the processor segments of the group and to accumulate the received products.

15. A computer, comprising one or more memories of at least one of the claims 9 to 13, or comprising an in-memory processor according to claim 14.
